# EUROPEAN PATENT SPECIFICATION

(11) **EP 1 118 938 B1**
(45) Date of publication and mention of the grant of the patent: **16.07.2003**
(21) Application number: 01101374.5
(22) Date of filing: 19.12.1997
(51) Int. Cl.: G01R 31/3185

(54) **A field programmable gate array with integrated debugging facilities**
Benutzerprogrammierbares Gatterfeld mit integrierten Fehlersuchsystemen
Circuit prédiffusé programmable doté d'un système intégré de débogage

(43) Date of publication of application: 25.07.2001
(62) Divisional of application: 97122571.9
(73) Proprietor: Mentor Graphics Corporation, Wilsonville, Oregon (US)
(72) Inventor: Barbier, Jean, Iussac, 92320 (FR); Lepape, Olivier, 75016 Paris (FR); Reblewski, Frederic, 91470 Les Molieres (FR)
(74) Representative: Patentanwälte Leinweber & Zimmermann

(56) References cited:
- US-A- 5 633 813
- US-A- 5 675 589

## Description

### BACKGROUND OF THE INVENTION

### 1. Field of the Invention

The present invention relates to the fields of field programmable gate array (FPGA) and emulation systems.

### 2. Background Information

Emulation systems for emulating circuit design are known in the art. Typically, prior art emulation systems are formed using general purpose FPGAs without integrated debugging facilities. A circuit design to be emulated is "realized" on the emulation system by compiling a "formal" description of the circuit design, and mapping the circuit design onto the logic elements (LEs) of the FPGAs.

These general purpose FPGAs, as far as their applications to emulation systems are concerned, have a number of disadvantages. First of all, the states of signals at the nodes mapped inside the FPGAs are not directly observable, thus the term "hidden" nodes. Secondly, in order to be able to observe the states of signals at these "hidden" nodes, reconfiguration, and therefore extremely time consuming recompilation is required to bring these signals outside the FPGAs to a logic analyzer. Thirdly, a number of the FPGA I/Os will have to be consumed for bringing these signals to the logic analyzer. Furthermore, the additional signals to be routed further increase signal routing congestion. Finally, for timing sensitive applications, it is difficult to know whether the signals at these "hidden" nodes were read at precisely the correct time or not, if the signals are to be read in response to the occurrence of certain events, since the signals have to be brought out of the FPGAs before the read triggering events can be detected.

The document US-A-5 675 589 discloses an FPGA circuit comprising a scan chain with sets of flip-flops and multiplexors for sequentially shifting test data through all LEs.

Thus, it is desirable to have an improved FPGA with integrated debugging facilities that is more suitable for usage by the emulation systems. As will be described in more detail below, the present invention as defined by independent claim 1 provides for such an improved FPGA with integrated debugging facilities that achieves these and other desired results, which will be apparent to those skilled in the art from the description to follow.

### SUMMARY OF THE INVENTION

An improved FPGA having integrated debugging facilities is disclosed. The improved FPGA comprises a number of enhanced logic elements (LEs) interconnected to each other, preferably, via a network of crossbars. Each enhanced LE comprises a multiple input-single output truth table and a complementary pair of master-slave latches having a data, a set and a reset input, and control logic. As a result, the enhanced LE may be used for "level sensitive" as well as "edge sensitive" circuit design emulations. Each enhanced LE further comprises a plurality of multiplexors and buffers, allowing each LE to be individually initialized, its state to be froze momentarily, and the frozen state to be read or modified.

Additionally, the improved FPGA further comprises a complementary context bus and read/write facilities for setting the enhanced LEs' initial values, and for reading of their frozen states. The improved FPGA also comprises a scan register for outputting trace data for the enhanced LEs. Lastly, the improved FPGA also comprises a plurality of trigger circuitry for conditionally generating a plurality of trigger inputs.

### BRIEF DESCRIPTION OF DRAWINGS

The present invention will be described by way of exemplary embodiments, but not limitations, illustrated in the accompanying drawings in which like references denote similar elements, and in which:
**Figure 1** illustrates the major functional blocks of the FPGA of the present invention;
**Figure 2** illustrates one embodiment of the LE array of **Fig. 1**, and one embodiment of the enhanced LE;
**Figure 3** illustrates one embodiment each of the control logic and input selector for the master-slave latches of **Fig. 1;**
**Figures 4a - 4b** illustrate one embodiment of the inter-LE crossbar network of **Fig. 1**
Figure 5 illustrates one embodiment of the inter-FPGA crossbar network stage0 of **Fig. 1**;
**Figure 6** illustrates one embodiment of the associated read/write facilities of the context bus of **Fig. 1;**
**Figures 7a - 7b** are two exemplary timing diagrams illustrating the reading of a value from a LE and the writing of a value into a LE;
**Figure 8** illustrates one embodiment of the scan register of **Fig. 1**; and
**Figure 9** illustrates one embodiment of the trigger circuitry of **Fig. 1**.

### DETAILED DESCRIPTION OF THE INVENTION

In the following description, for purposes of explanation, specific numbers, materials and configurations are set forth in order to provide a thorough understanding of the present invention. However, it will be apparent to one skilled in the art that the present invention may be practiced without the specific details. In other instances, well known features are omitted or simplified in order not to obscure the present invention.

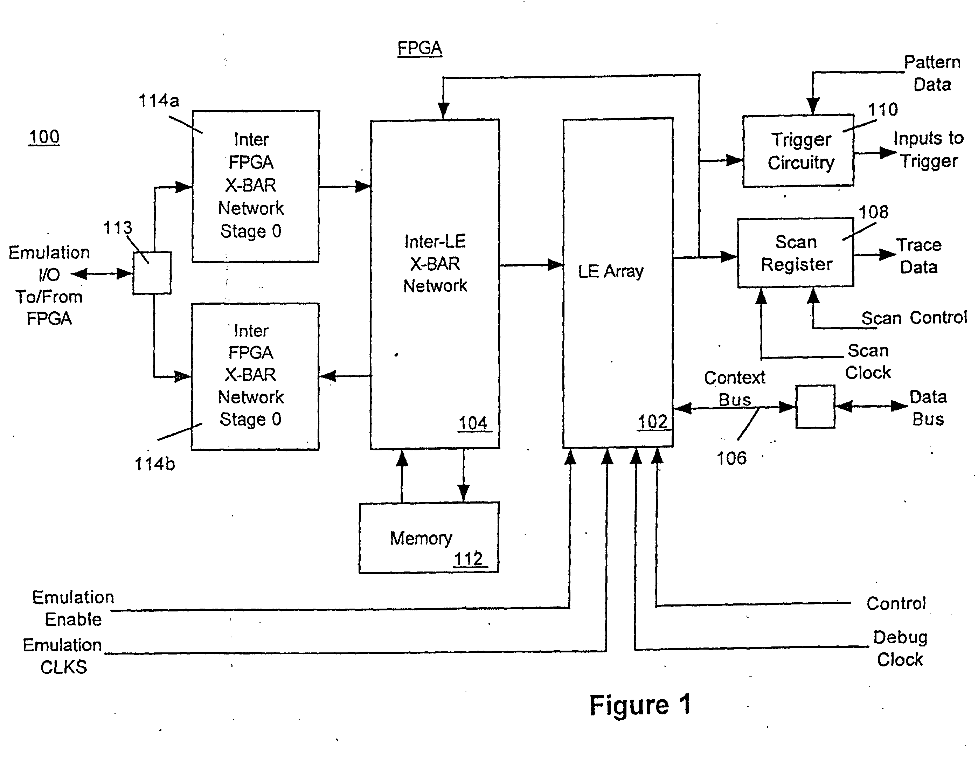

Referring now to **Figure 1**, the major functional blocks of improved FPGA **100** of the present invention are illustrated. As shown, FPGA **100**, which is disposed on a single integrated circuit (or chip), comprises an array **102** of enhanced LEs incorporated with the teachings of the present invention. As in the prior art, the enhanced LEs are used to "realize" various elements of circuit designs, however, as will be disclosed in more detail below, unlike the prior art, the enhanced LEs include new and innovative debugging features.

Additionally, FPGA **100** further advantageously includes on-chip context bus **106,** scan register **108** and trigger circuitry **110,** coupled to the enhanced LEs as shown. As will be disclosed in more detail below, context bus **106** is used for inputting and outputting values to and from the LEs, whereas scan register **108** and trigger circuitry **110** are used to output trace data and trigger inputs for FPGA **100** respectively.

Preferably, FPGA **100** includes memory **112** to facilitate usage of FPGA **100** for emulating circuit designs with memory. In one embodiment, memory **112** is 16-bit wide. Preferably, the pins **113** of FPGA **100** can be used for either input or output. In one embodiment, 64 I/O pins **113** are provided to FPGA **100.** Preferably, FPGA **100** also includes inter-LE crossbar (or x-bar) network **104** for interconnecting the LEs, memory **112,** and I/O pins **113,** as shown. Finally, it is also preferable for FPGA **100** to include "two copies" of the first stage of a crossbar network **114a - 114b** for inter-connecting FPGA **100** to other FPGAs and a "host system".

Memory **112** is well known in the art and will not be further described. Inter-LE crossbar network **104** and the first stage of inter-FPGA crossbar network **114a -** will be briefly described below. LEs, context bus **106,** scan register **108,** and trigger circuitry **110** will be described in further detail below with additional references to the remaining figures.

Before describing these elements in further detail, it should be noted that while for ease of explanation, the present invention is being described in the context of emulation, however, based on the description to follow, a person skilled in the art will appreciate that the present invention may be adapted for other applications beside emulation systems.

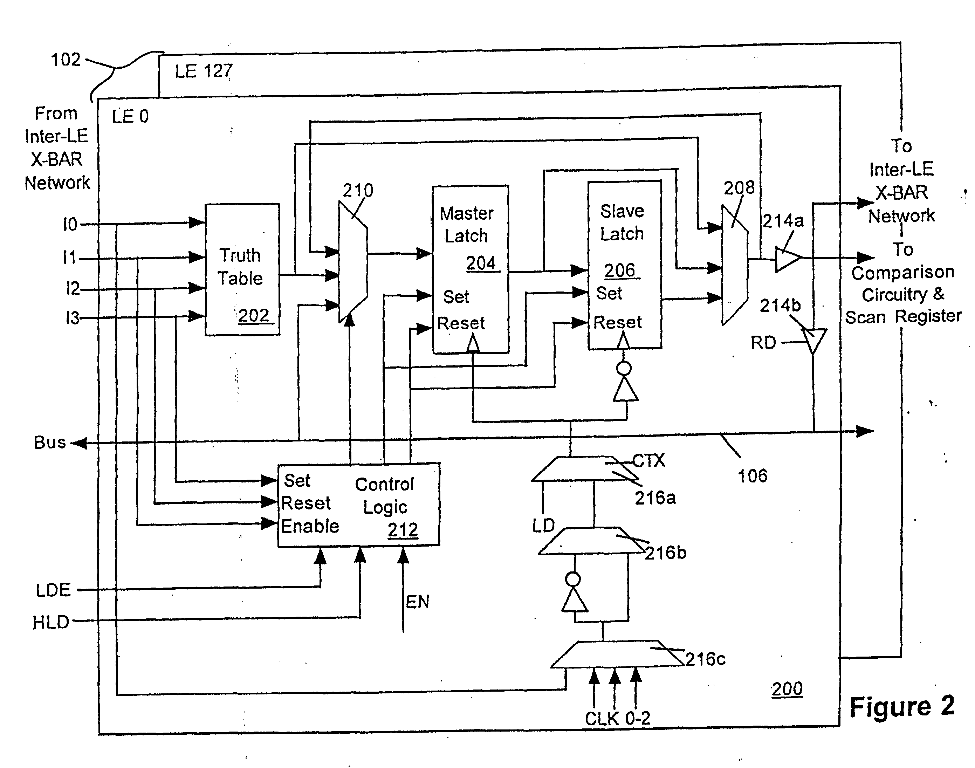

**Figure 2** illustrates one embodiment of the array of enhanced LEs of **Fig.1** and one embodiment of the LEs themselves in further detail. As shown, LE array **102** comprises a plurality of enhanced LEs **200** of the present invention. In one embodiment, LE array **102** comprises **128** LEs **200.** Each LE **200** includes a multiple input - single output truth table **202,** a pair of master-slave latches **204- 206,** output multiplexor **208,** input multiplexor **210,** and control logic **212,** coupled to each other as shown.

Truth table **202** is used to generate a predetermined output in response to a set of inputs. For the illustrated embodiment, truth-table **202** has 4 inputs and 1 output. In other words, depending on the inputs, truth table **202** outputs 1 of 2⁴ of predetermined outputs. Each of master-slave latches **204 - 206** is used to store an input value synchronously with its clock input. Furthermore, each of master-slave latches **204 - 206** can be asynchronously forced to one or zero depending on the values of set and reset. For the illustrated embodiment, the set and reset inputs are provided using the inputs I3 and I2 of truth table **202.** In other words, if set/reset is used, the number of input variations that can be provided to truth-table **202** are reduced. Alternatively, additional dedicated pins may be provided to provide the set/reset signals to master-slave latches **204 - 206,** however the real estate requirement of the FPGA will be increased.

Output multiplexor **208,** input multiplexor **210** and control logic **212** are used to control the manner in which truth table **202** and master-slave latches **204 - 206** are used. Output multiplexor **208** allows either the output of truth table **202** (bypassing master-slave latches **204 - 206**) or the output of slave latch **206** (for level sensitive designs), or the output.of master latch **204** (for edge sensitive designs) to be selected for output. The by-passed output is selected if truth table **202** is to be used standalone. When either the output of master or slave latch **204** or **206** is selected, input multiplexor **210** allows either the output of truth table **202,** the feedback from output multiplexor **208,** or an input value on context bus **106** to be provided to master-slave latches **204 - 206.** The feedback value is selected to "freeze" LE **200,** and the bus value is selected to initialize LE **200.** Control logic **212** controls input multiplexor **210** and the set and reset values provided to master-slave latches **204 - 206,** in accordance to a set, a reset, a first and a second enable (ENAB and EN), a load (LDE) and a hold (HLD) value provided, to be described more fully below.

Each LE **200** also includes clock selection multiplexors **216a - 216c** for selectively providing a number of emulation clocks or a debug clock (LD) to master-slave latches **204 - 206.** Preferably, the emulation clocks include a "constructed" emulation clock using other LEs **200.** For the illustrated embodiment, this "constructed" emulation clock is made available through I0 of truth table **202.** One of the emulation clocks is provided to master-slave latches **204 - 206** during normal operation, whereas the debug clock (LD) is provided during debugging. The clock selection is controlled by the CTX signal. Lastly, LE **200** also includes buffer **214a** for outputting the selected output to inter-LE X-bar network **104** and the on-chip debugging facilities, and buffer **214b** for outputting the selected output onto context bus **106** for direct observation outside FPGA **100**.

In sum, truth table **202** may be used in a standalone manner, or in conjunction with the corresponding master-slave latches **204 - 206**. Enhanced LE **200** is suitable for "level sensitive" as well as "edge sensitive" circuit design emulations. Additionally, beside the "normal" current output of truth table **202,** each LE **200** can be individually initialized. Each LE **200** can also be caused to output the same output over and over again, as if it is frozen. Furthermore, LEs **200** are individually and directly observable outside FPGA **100.** In other words, there are no "hidden nodes". The state of each "node" is directly observable outside the FPGA, without requiring the reconfiguration and time consuming re-compilation of circuit design mappings normally performed under the prior art.

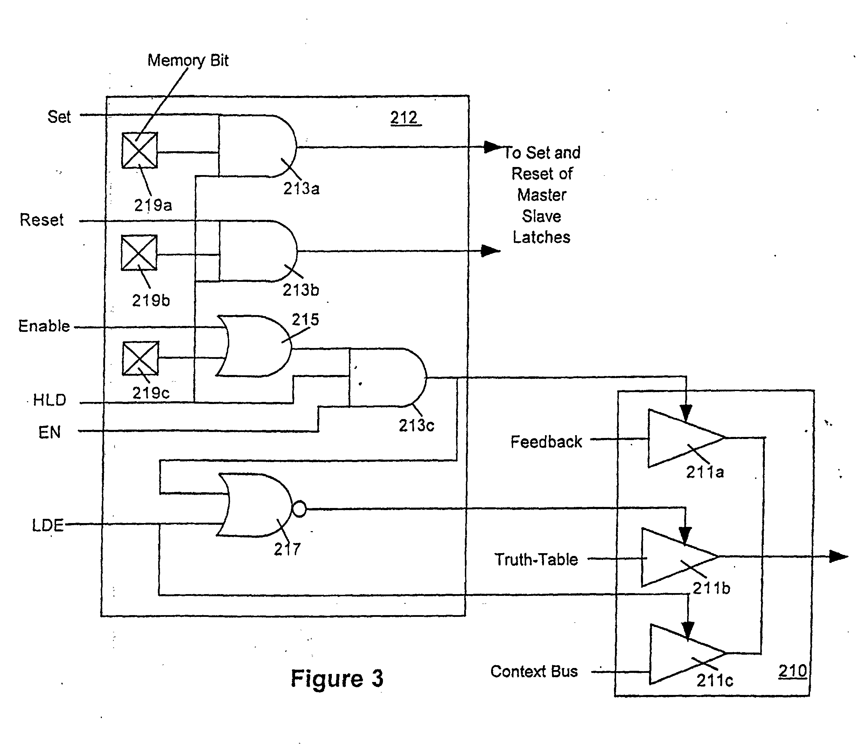

**Figure 3** illustrates one embodiment each of input multiplexor **210** and control logic **212** in further detail. As shown, multiplexor **210** comprises drivers **211a** - **211c** for outputting the feedback output, the output of truth-table **202,** and the input value on context bus **106** respectively, if enabled. One of drivers **211a - 211c** is selectively enabled by control signals from control logic **212.** Control logic **212** comprises AND gates **213a - 213c,** OR gate **215,** NOR gate **217,** and memory bits **219a - 219c** for generating the control signals for driver **211a - 211c,** as well as the set and reset values for master-slave latches **204- 206.** Memory bits **219a - 219c** are used to store configuration information for enabling the provision of the set and reset values and the selection of the feedback output. If enabled, AND gates **213a - 213b** provides the set and reset values in accordance to the set and HLD inputs, and the reset and HLD inputs respectively. If enabled, OR gate **215** in conjunction with AND gate **213c** provide the control signal for driver **211a** in accordance to the ENAB, HLD and EN inputs. NOR gate **217** provide the control signal for driver **211b** in accordance to the control signal being provided for driver **211a** and a LDE input. Lastly, the LDE input is provided as the control signal for driver **211c.**

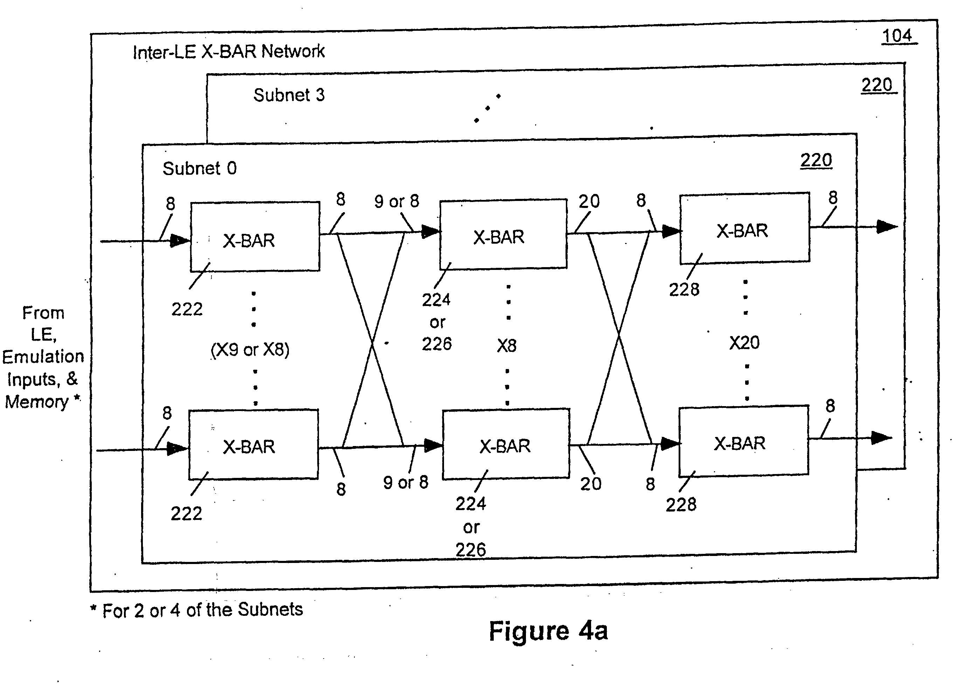

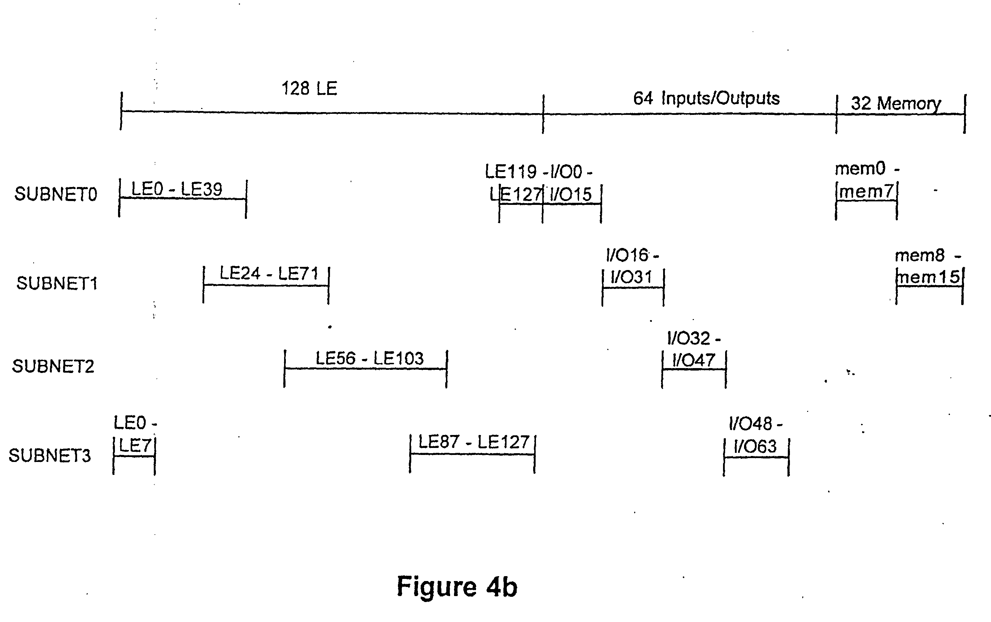

Referring now briefly to **Figures 4a - 4b,** wherein one embodiment of inter-LE crossbar network **104** for interconnecting the LEs, the memory and the I/O pins is illustrated. As shown in **Fig. 4a,** for the illustrated embodiment, inter-LE crossbar network **104** comprises 4 subnetworks **220.** The first two subnetworks, subnet0 and subnet1, are used to route **72** signals, whereas the remaining two subnetworks, subnet2 and subnet3, are used to route 64 signals. More specifically, as shown in **Fig. 4b,** Subnet0 is used to route the signals of LE0 - LE39, LE119 - LE127, I/O0 - I/O15 and M0 - M7. Subnet1 is used to route the signals of LE24 - LE71, I/O16 - I/O31 and M8 - M15. Subnet2 is used to route the signals of LE56 - LE103, and I/O32-I/O47. Subnet3 is used to route the signals of LE0 - LE7, LE88 - LE127, and I/O48 - I/O63. The overlapping coverage of the LEs provides increased flexibility of signal routing for mapping circuit designs.

Each subnetwork **220** is a three-stage Claus network comprising either 9 or 8 8-to-8 crossbars **222** in the first stage, 8 9-to-20 or 8-to-20 crossbars **224** or **226** in stage two, and 20 8-to-8 crossbars **228** in stage three. The stages are coupled to each other in the well known "butterfly" manner.

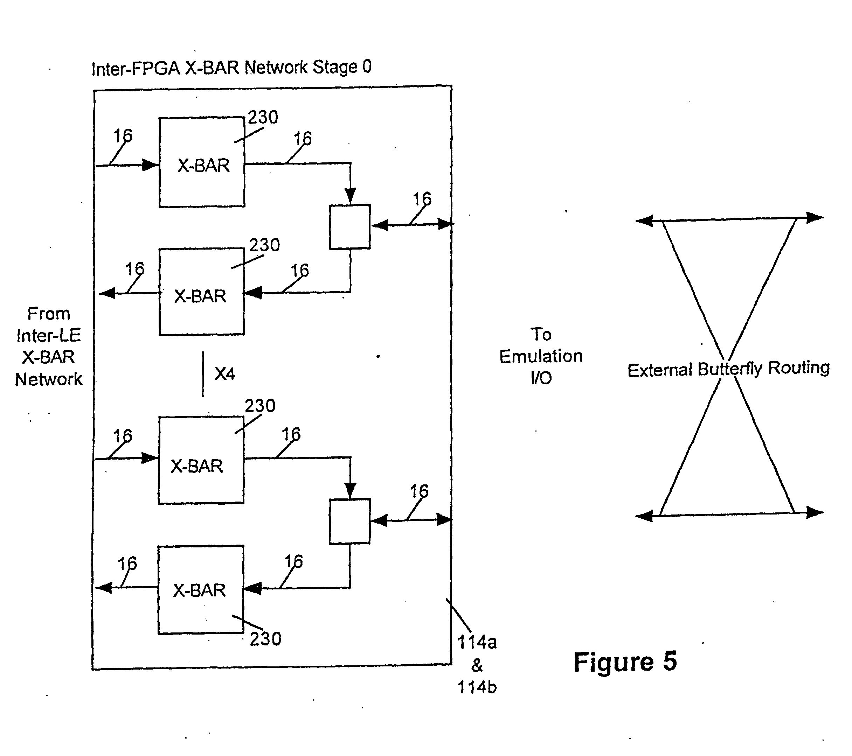

Referring now also briefly to **Figure 5,** wherein one embodiment of inter-FPGA crossbar network stage0 **114a - 114b** for interconnecting the FPGA to other FPGAs and a "host" computer is illustrated. As shown, for the illustrated embodiment, inter-FPGA crossbar network stage0 **114a - 114b** comprises 4 pairs of 16-to-16 crossbars **230** for coupling 64 I/O signals of the FPGA to the next stage of a Claus network for interconnecting the FPGA to other FPGAs and a "host" computer.

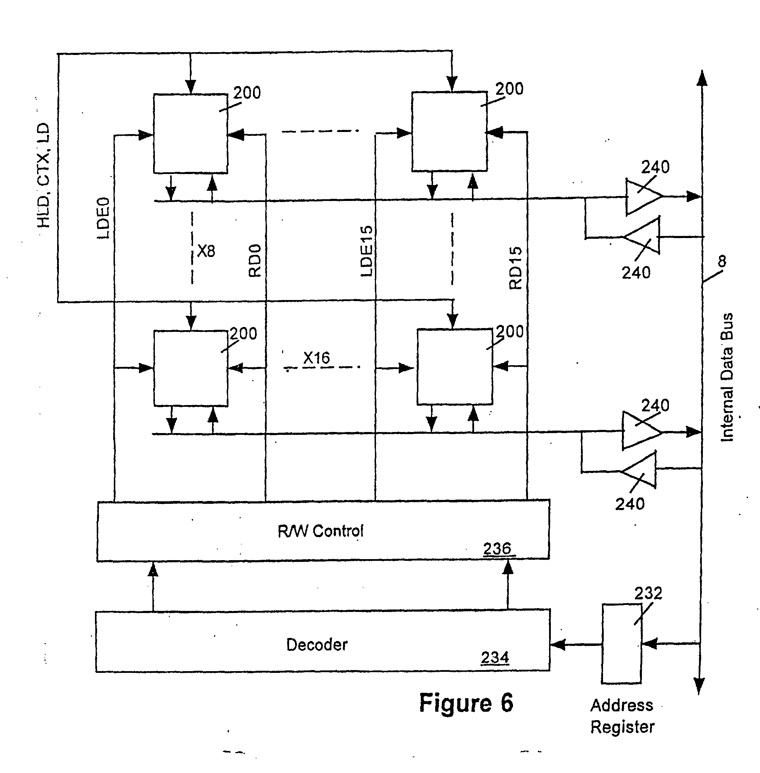

**Figure 6** illustrates one embodiment of the read/write facilities associated with context bus **106** for reading from and writing into LEs **200** of FPGA **100**. As shown, for the illustrated embodiment, 128 LEs **200** are organized in 16 columns, with each column having 8 LEs **200.** Thus, all 128 LEs **200,** or the current context, can be read or written with 16 8-bit words. Address register **232** is provided for storing the read or write-address. Decoder **234** is provided for decoding the read or write address, which in conjunction with R/W control **236** provide the appropriate read control signals (RD0 - RD15) and write control signals (LDE0 - LDE15) for the 128 LEs **200.** Additionally, each LE **200** receives the earlier described HLD signal for "freezing" the LEs **200,** the CTX signal for selecting the debug (LD) clock, and the LD clock itself.

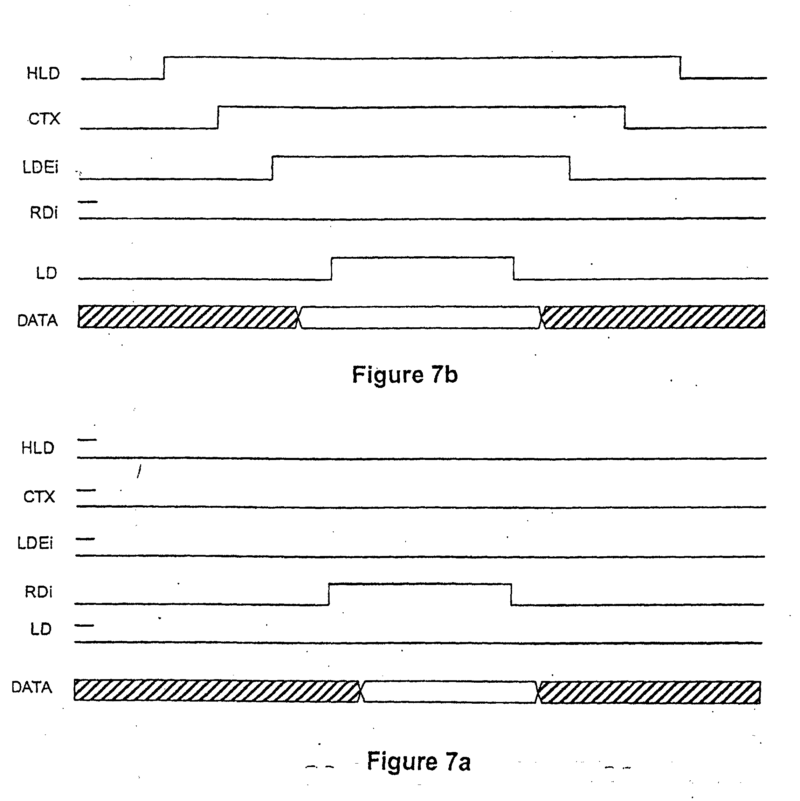

**Figures 7a - 7b** illustrate exemplary signal timings for reading and writing. As shown in **Fig. 7a,** context reading is done by first loading a 4-bit address into address register **232.** As a result, decoder **234** causes R/W control **236** to drive the appropriate RD signals high to read out the contents of the addressed LEs **200.** (HLD, CTX, LDEi and LD all remain low while a read operation is in progress.) As shown in **Fig. 7b,** context writing is done by first loading a 4-bit address into address register **232.** Additionally, before decoder **234** responds and causes R/W control **236** to drive the appropriate LDE signals high, HLD is first driven high to freeze all LEs **200.** Furthermore, CTX is driven high to select debug clock LD for each LE **200.** Then, when R/W control **236** drives the appropriate LDE signals, values on context bus **106** are loaded into the addressed LEs **200.** It is important to freeze all LEs **200** during a context writing, because partial context could induce temporary states, which could in turn put an emulation system into an unknown state. For example, the final context may drive a given RESET signal to the low state, but the partial context (during the writing operation) may induce a temporary high state on the RESET signal, thus unpredictably resetting all the latches connected to the signal.

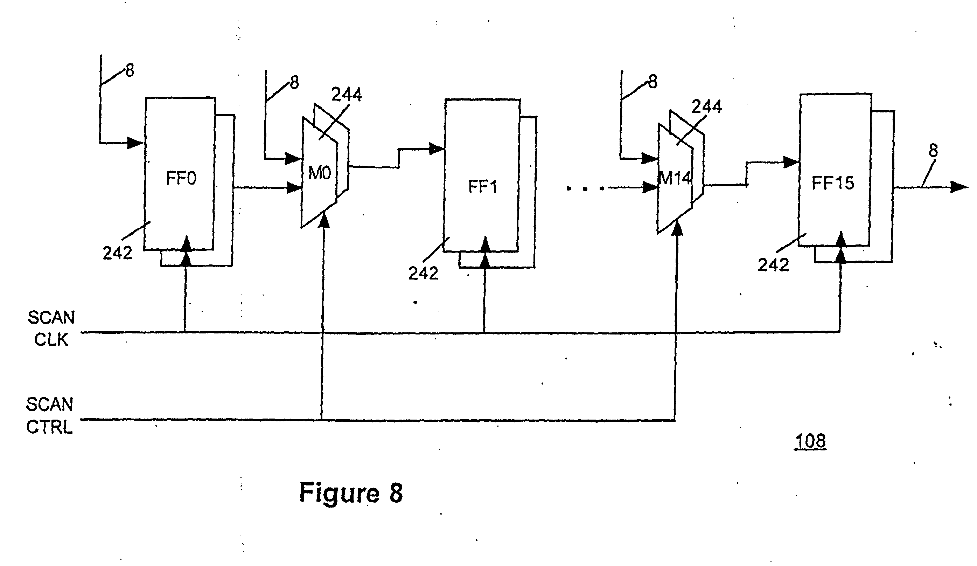

**Figure 8** illustrates one embodiment of scan register **108** for outputting trace data. As shown, for the illustrated embodiment, scan register **108** comprises 16 sets of 8 flip-flops **242,** and 15 sets of 8 multiplexors **244,** disposed in between flip-flop sets **242.** Flip-flop set0 **242** is coupled to a first group of 8 LEs **200.** Multiplexor set0 **244** is coupled to flip-flop set0 **242** and a second group of LEs **200.** Flip-flop set1 **242** is coupled to multiplexor set0, and so forth. Flip-flop set0 **242** sequentially receives and propagates the outputs of the first group of 8 LEs **200.** Multiplexor set0 **242** either serially provides the outputs of flip-flop set0 **242** or the outputs of the second group of 8 LEs. Flip-flop set1 **242** in turn sequentially propagates the inputs it received from multiplexor set0 **244.** Flip-flop sets **242** are controlled by a scan clock, whereas, multiplexor sets **244** are controlled by a scan control signal. Thus, by applying a scan clock having the appropriate divided frequency (relative to the operating emulation clock), and selectively applying the appropriate scan control signal to the multiplexor sets **244,** a snapshot of 128 LEs at a particular clock cycle can be sequentially scanned out of FPGA **100.**

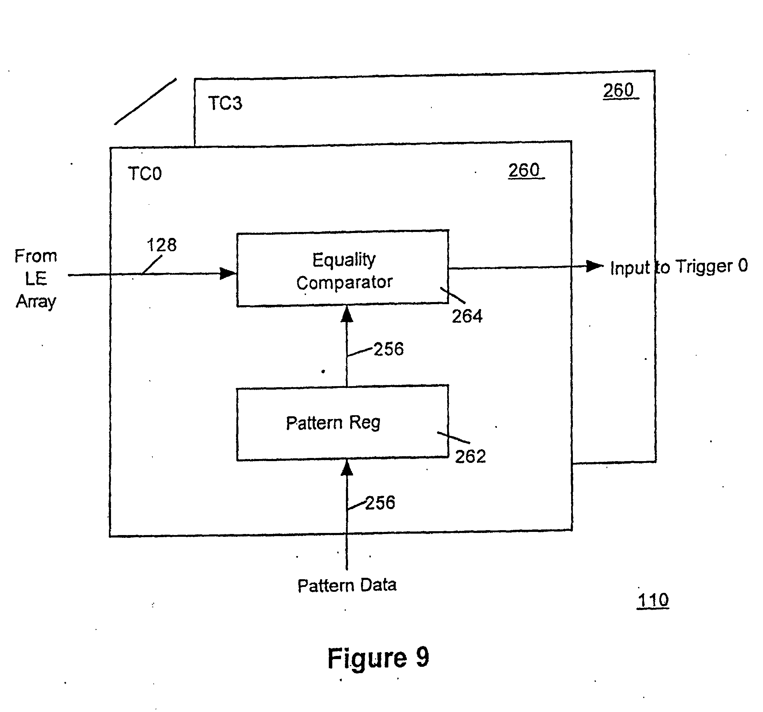

**Figure 9** illustrates one embodiment of trigger circuitry **110** for outputting trigger inputs. As shown, for the illustrated embodiment, trigger circuitry **110** comprises 4 comparator-register circuits **260** for generating 4 trigger inputs, one from each comparator-register circuit **260.** Each comparator-register circuit **260** includes a register **262** for storing a signal pattern, and an equality comparator **264** for comparing the outputs of the LEs to the stored content of pattern register 262. In one embodiment, the signal pattern comprises 2-bits per LE **200,** allowing the values of High, Low, or Don't Care to be encoded. An input to a trigger outside FPGA **100** is generated whenever the stored pattern is detected. In other words, for the illustrated embodiment, 4 LE internal state events can be monitored simultaneously.

Thus, an improved FPGA with integrated debugging facility that is particularly suitable for emulation systems has been described. While the method and integrated circuit of the present invention has been described in terms of the above illustrated embodiments, those skilled in the art will recognize that the invention is not limited to the embodiments described. The present invention can be practiced with modification and alteration within the scope of the appended claims. The description is thus to be regarded as illustrative instead of restrictive on the present invention.

## Claims

1. A single integrated field programmable gate array (FPGA) circuit (100) comprising a plurality of logic elements (LEs) (200) for generating a plurality of output signals in response to a plurality of input signals correspondingly applied to the LEs (200), and means for capturing and outputting signal state values of the LEs (200);
**characterized in that**
said capturing means comprises a scan register (108) coupled to the LEs (200) for serially capturing and outputting a trace record of all signal state values of the LEs (200) in a particular clock cycle of an operating clock outside the integrated circuit, the scan register (108) comprising n sets (242) of m flip-flops and (n-1) sets (244) of m multiplexors serially coupled to each other with the (n-1) sets (244) of multiplexors interposed in between the n sets (242) of flip-flops, each of the (n-1) multiplexor sets (244) and a first of the n flip-flop set being also correspondingly coupled to 1/n of the LEs (200), and the scan register (108) being provided with a scan clock appropriately scaled to the operating clock;
said FPGA circuit further comprising trigger circuitry (110) coupled to the LEs (200) for conditionally generating at least one trigger value depending on the signal state values of the LEs (200).

2. The integrated circuit as set forth in claim 1, wherein the trigger circuitry (110) comprises
a first register (262) for storing a first trigger pattern; and
a first comparator (264) coupled to the LEs (200) and the first register (262) for conditionally generating a first trigger value if signal state values of the LEs (200) match the stored first trigger pattern.

3. The integrated circuit as set forth in anyone of claims 1 or 2, wherein
each LE (200) further includes a multiple input-single output truth table (202) for generating a first intermediate output signal in response to a first set of input signals;
a context bus (106) coupled to the LEs (200) for outputting individual signal state values of the LEs (200) out of the integrated circuit, and for initializing the LEs (200) with individual signal state values provided to the integrated circuit while the output signals of the LEs (200) are being held constant;
a first selector (210) coupled to the truth table (202) and the context bus (106) for selecting either the first intermediate output signal, or the output of the LE (200) fed back to the first selector (210), and outputting the selected signal; and
a first control circuit (212) coupled to the first selector (210) for controlling the first selector.

4. The integrated circuit as set forth in claim 3, wherein each LE (200) further comprises
a pair of master-slave latches (204, 206), each having a data input, a set input, and a reset input, coupled to the first selector (210) for generating a second and a third intermediate output signal in response to the data, set, and reset inputs, the selected and third intermediate output signals being provided as data inputs to the master and slave latches respectively;
a second control circuit (212) coupled to the pair of master-slave latches (204, 206) for providing each of the master and slave latches with a set and a reset value; and
a second selector (208) coupled to the truth table (202) and the master-slave latches (204, 206) for selecting either the first, second or third intermediate output signal as the output signal of the LE (200).

5. The integrated circuit as set forth in claim 4, wherein the LE (200) further comprises a third selector (216a) for selectively providing either an emulation clock or a debugging clock to the master and slave latches (204, 206).

## Patentansprüche

1. Einzelner integrierter benutzerprogrammierbarer Gatterfeldschaltkreis (FPGA) (100) mit einer Vielzahl logischer Elemente (LEs) (200) zur Erzeugung einer Vielzahl von Ausgangssignalen ansprechend auf eine Vielzahl an die LEs (200) entsprechend angelegter Eingangssignale und einer Einrichtung zur Erfassung und Ausgabe von Signalzustandswerten der LEs (200),
**dadurch gekennzeichnet, daß**
die Erfassungseinrichtung ein mit den LEs (200) gekoppeltes Abtastregister (108) zur seriellen Erfassung und Ausgabe einer Ablaufprotokollaufzeichnung aller Signalzustandswerte der LEs (200) in einem bestimmten Taktzyklus eines Betriebstakts aus dem integrierten Schaltkreis heraus aufweist, wobei das Abtastregister (108) n Sätze (242) von m Flip-Flops und (n-1) Sätze (244) von m Multiplexern aufweist, die seriell unter Zwischenfügung der (n-1) Sätze (244) von Multiplexern zwischen die n Sätze (242) von Flip-Flops miteinander gekoppelt sind, von denen jeder der (n-1) Multiplexer-Sätze (244) und ein erster der n Flip-Flop-Sätze auch entsprechend mit 1/n der LEs (200) gekoppelt ist und das Abtastregister (108) mit einem in bezug auf den Betriebstakt geeignet skalierten Abtasttakt versehen ist;
der FPGA-Schaltkreis ferner eine mit den LEs (200) gekoppelte Triggerschaltung (110) zur bedingten Erzeugung mindestens eines Triggerwertes in Abhängigkeit von den Signalzustandswerten der LEs (200) aufweist.

2. Integrierter Schaltkreis nach Anspruch 1, wobei die Triggerschaltung (110) aufweist
ein erstes Register (262) zur Speicherung eines ersten Triggermusters, und
einen mit den LEs (200) und dem ersten Register (262) gekoppelten ersten Komparator (264) zur bedingten Erzeugung eines ersten Triggerwertes, wenn die Signalzustandswerte der LEs (200) mit dem gespeicherten ersten Triggermuster übereinstimmen.

3. Integrierter Schaltkreis nach einem der Ansprüche 1 oder 2, wobei
jedes LE (200) ferner eine Wahrheitstabelle (202) mit mehreren Eingängen und einem einzigen Ausgang zur Erzeugung eines ersten Zwischenausgangssignals ansprechend auf einen ersten Satz von Eingangssignalen aufweist,
einen mit den LEs (200) gekoppelten Kontextbus (106) zur Ausgabe einzelner Signalzustandswerte der LEs (200) aus dem integrierten Schaltkreis heraus und zur Initialisierung der LEs (200) mit einzelnen Signalzustandswerten, die an den integrierten Schaltkreis angelegt werden, während die Ausgangssignale der LEs (200) konstant gehalten werden,
einen an die Wahrheitstabelle (202) und den Kontextbus (106) gekoppelten ersten Wähler (210) zum Auswählen entweder des ersten Zwischenausgangssignals oder des zu dem ersten Wähler (210) zurückgeführten Ausgangssignals des LE (200) und Ausgeben des ausgewählten Signals, und
einen mit dem ersten Wähler (210) gekoppelten ersten Steuerschaltkreis (212) zur Steuerung des ersten Wählers.

4. Integrierter Schaltkreis nach Anspruch 3, wobei jedes LE (200) ferner aufweist
ein Paar aus jeweils einen Dateneingang, einen Setzeingang und einen Rücksetzeingang aufweisenden Master-Slave-Halteschaltungen (204, 206), das mit dem ersten Wähler (210) zur Erzeugung eines zweiten und dritten Zwischenausgangssignals ansprechend auf die Daten-, Setz- und Rücksetzeingänge gekoppelt ist, wobei das gewählte und das dritte Zwischenausgangssignal als Dateneingänge an die Master- bzw. Slave-Halteschaltung angelegt werden,
einen mit dem Paar aus Master-Slave-Halteschaltungen (204, 206) gekoppelten zweiten Steuerschaltkreis (212) zur Belieferung sowohl der Master- als auch der Slave-Halteschaltung mit einem Setz- und einem Rücksetzwert, und
einen mit der Wahrheitstabelle (202) und den Master-Slave-Halteschaltungen (204, 206) gekoppelten zweiten Wähler (208) zum Wählen entweder des ersten, zweiten oder dritten Zwischenausgangssignals als das Ausgangssignal des LE (200).

5. Integrierter Schaltkreis nach Anspruch 4, wobei das LE (200) ferner einen dritten Wähler (216a) zur selektiven Anlegung entweder eines Emulationstakts oder eines Fehlersuchtakts an die Master- und Slave-Halteschaltungen (204, 206) aufweist.

## Revendications

1. Circuit intégré de réseau de portes programmable sur site (FPGA) (100) unique comprenant une pluralité d'éléments logiques (Le) (200) pour générer une pluralité de signaux de sortie en réponse à une pluralité de signaux d'entrée appliqués de manière correspondante aux éléments logiques (200) et des moyens pour capturer et délivrer des valeurs d'état de signaux des éléments logiques (200) ;
**caractérisé en ce que**
lesdits moyens de capture comprennent un registre de balayage (108) couplé aux éléments logiques (200) pour capturer en série et délivrer un enregistrement de traces de toutes les valeurs d'état de signaux des éléments logiques (200) dans un cycle d'horloge particulier d'une horloge de commande à l'extérieur du circuit intégré, le registre de balayage (108) comprenant n ensembles (242) de m bascules bistables et (n-1) ensembles (244) de m multiplexeurs couplés en série les uns aux autres, les (n-1) ensembles (244) de multiplexeurs étant interposés entre les n ensembles (242) de bascules bistables, chacun des (n-1) ensembles de multiplexeurs (244) et un premier ensemble parmi les n ensembles de bascules bistables étant également couplés de manière correspondante à 1/n des éléments logiques (200), et le registre de balayage (108) étant pourvu d'une horloge de balayage adaptée de manière appropriée à l'horloge de commande ;
ledit circuit de réseau de portes programmable sur site comprenant, en outre, des éléments de circuit de déclenchement (110) couplés aux éléments logiques (200) pour générer de manière conditionnelle au moins une valeur de déclenchement en fonction des valeurs d'état de signaux des éléments logiques (200).

2. Circuit intégré selon la revendication 1, dans lequel les éléments de circuit de déclenchement (110) comprennent
un premier registre (262) pour mémoriser un premier modèle de déclenchement ; et
un premier comparateur (264) couplé aux éléments logiques (200) et au premier registre (262) pour générer de manière conditionnelle une première valeur de déclenchement si des valeurs d'état de signaux des éléments logiques (200) correspondent au premier modèle de déclenchement mémorisé.

3. Circuit intégré selon l'une quelconque des revendications 1 ou 2, dans lequel
chaque élément logique (200) comprend, en outre, une table de vérité à entrées multiples et à sortie unique (202) pour générer un premier signal de sortie intermédiaire en réponse à un premier ensemble de signaux d'entrée ;
un bus de contexte (106) couplé aux éléments logiques (200) pour sortir des valeurs d'état de signaux individuelles des éléments logiques (200) du circuit intégré et pour initialiser les éléments logiques (200) avec des valeurs d'état de signaux individuelles fournies au circuit intégré tandis que les signaux de sortie des éléments logiques (200) sont maintenus constants ;
un premier sélecteur (210) couplé à la table de vérité (202) et au bus de contexte (106) pour sélectionner soit le premier signal de sortie intermédiaire, soit la sortie de l'élément logique (200) renvoyée au premier sélecteur (210), et délivrer le signal sélectionné ; et
un premier circuit de commande (212) couplé au premier sélecteur (210) pour commander le premier sélecteur.

4. Circuit intégré selon la revendication 3, dans lequel chaque élément logique (200) comprend en outre
deux bascules maître-esclave (204, 206), ayant chacune une entrée de données, une entrée de positionnement et une entrée de réinitialisation, couplées au premier sélecteur (210) pour générer un deuxième et un troisième signal de sortie intermédiaire en réponse aux entrées de données, de positionnement et de réinitialisation, le signal de sortie sélectionné et le troisième signal de sortie intermédiaire étant respectivement appliqués en tant qu'entrées de données aux bascules maître et esclave ;
un deuxième circuit de commande (212) couplé aux deux bascules maître-esclave (204, 206) pour fournir à chacune des bascules maître et esclave une valeur de positionnement et de réinitialisation ; et
un deuxième sélecteur (208) couplé à la table de vérité (202) et aux bascules maître-esclave (204, 206) pour sélectionner le premier, le deuxième ou le troisième signal de sortie intermédiaire en tant que signal de sortie de l'élément logique (200).

5. Circuit intégré selon la revendication 4, dans lequel l'élément logique (200) comprend, en outre, un troisième sélecteur (216a) pour délivrer, de manière sélective, soit une horloge d'émulation, soit une horloge de débogage, aux bascules maître et esclave (204, 206).
